Europäisches Patentamt

European Patent Office

Office européen des brevets

(11) Publication number: **0 039 970**
**B1**

(12) **EUROPEAN PATENT SPECIFICATION**

(45) Date of publication of patent specification: **19.12.84**

(21) Application number: **81200476.0**

(22) Date of filing: **06.05.81**

(51) Int. Cl.³: **H 03 B 5/04,** H 03 B 9/14

(54) R.F. oscillator arrangement.

(30) Priority: **09.05.80 GB 8015503**
**03.04.81 GB 8110510**

(43) Date of publication of application:
**18.11.81 Bulletin 81/46**

(45) Publication of the grant of the patent:
**19.12.84 Bulletin 84/51**

(84) Designated Contracting States:
**DE FR GB SE**

(56) References cited:
**EP-A-0 034 510**
**GB-A-1 238 956**
**GB-A-2 026 800**
**GB-A-2 032 715**
**US-A-3 753 153**
**US-A-4 151 488**

**Patents Abstracts of Japan, Vol. 4, No. 52, 18 April 1980, page 107E7**

(73) Proprietor: **PHILIPS ELECTRONIC AND ASSOCIATED INDUSTRIES LIMITED Arundel Great Court 8 Arundel Street London WC2R 3DT (GB)**

㉘④ **GB**

(73) Proprietor: **N.V. Philips' Gloeilampenfabrieken Groenewoudseweg 1 NL-5621 BA Eindhoven (NL)**

㉘④ **DE FR SE**

(72) Inventor: **Davies, Robert c/o Philips Research Laboratories Redhill Surrey, RH1 5HA (GB)**

(74) Representative: **Boxall, Robin John et al Philips Electronic and Associated Ind. Ltd. Patent Department Mullard House Torrington Place London WC1E 7HD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to an R.F. oscillator arrangement comprising a TRAPATT diode operable to produce pulses of radio frequency energy when pulses of direct current greater than a critical current are applied to the diode, the radio frequency being dependent on the temperature of the diode.

Present theory and experience indicate that the TRAPATT mode is a large-signal mode that develops from a small-signal negative resistance. There is a critical bias current below which negligible, if any, microwave energy is generated. This critical current is high, e.g. a typical S-band p-n junction TRAPATT diode with a junction area of $4.10^{-4}$ cm² has a critical bias current of about 1—2 amps when mounted in an oscillator circuit that is typically of the time-delayed-triggered (T.D.T.) type, for example as described by W. J. Evans in "Circuits for high-efficiency avalanche-diode oscillators", I.E.E.E. Trans. MTT-*17* 1060, (1969), or as described in U.K. Patent Applications Nos. 2026800 and 2032715.

In common with other oscillators the frequency of free running TRAPATT oscillators varies with the diode and circuit temperatures which are of course functions of the ambient temperature. Both coaxial and microstrip S-band (about 2.5 GHz) TRAPATT oscillators have been measured by the applicants over wide temperature ranges, for example —50°C to +100°C and the frequency-temperature characteristic has been negative and typically approximately linear with a value of between about —300 kHz/°C and —400 kHz/°C for flip-chip diodes.

The temperature of the circuit affects the operating frequency because of the coefficient of linear expansion of the metal structure of the oscillator and the temperature dependence of the permitivity of any dielectric material in the delay-line associated with the T.D.T. circuit. Increasing temperature increases the length of the oscillator structure and generally increases the permitivity of dielectrics in the delay line such as polystyrene supports in a coaxial oscillator or the alumina substrate in a microstrip version; both of these effects are such as to cause the oscillation frequency to decrease with increasing temperature. However, the variation of frequency calculated from the temperature dependence of these parameters is considerably less than that observed in such oscillators (which is about 300 to 400 kHz/°C).

The temperature of the diode also determines the oscillation frequency. It is suggested that the effect of temperature on the device is such that, assuming a charging current that is independent of temperature, the time taken each R.F. cycle for the particle current to increase by avalanche multiplication to such a level that the displacement current is zero varies with diode temperature. The effect of this temperature dependence can be best appreciated by considering the device voltage-time characteristic. While the diode voltage is below the breakdown voltage the diode appears as a capacitor. Assuming the diode to be biased instantaneously below breakdown, a constant charging current will cause the voltage across the diode to increase linearly with time. As the voltage passes through breakdown and continues to increase with time, the number of charge-carriers in the depletion region starts to increase by avalanche multiplication. The voltage across the diode continues to increase until there are sufficient carriers to carry all the charging-current (at this point the displacement current is zero); the diode voltage has now reached a maximum from which it falls rapidly with the further increase in the number of carriers due to avalanche multiplication. (In a T.D.T. circuit, this collapse launches the trigger pulse into the delay-line circuit along which the pulse travels, the pulse polarity being inverted at a step transition and returning along the delay line to provide the next trigger. We have seen earlier that the circuit delay varies only a small amount with temperature). The time between the diode voltage passing through breakdown and reaching a maximum varies with temperature considerably via the ionization coefficients of holes and electrons, the saturated drift velocity and the saturation current; each of these parameters is a function of temperature, ionization and saturated drift velocity decreasing with increasing temperature while saturation current increases with increasing temperature. It is thought that the net negative frequency-temperature characteristic of TRAPATT diode oscillators is due to negative contributions from the ionization and saturated drift velocity and a positive contribution from the saturation current.

It has been proposed (see the published abstract of Japanese patent application 55-23628) to reduce the range of frequency variation of the pulse of a pulsed microwave oscillator by providing a temperature sensing element on the heat-sink of the oscillation element and using it to control the supply of electrical power to adjacent heating elements, to heat-sink and heating elements being mounted on a part made of thermal insulator; the ON and OFF set value of the temperature sensing element is selected slightly higher than the estimated ambient temperature. However, since the efficiency with which a direct current is converted to R.F. energy in a microwave oscillator is generally very much less than 100%, the production of a substantial amount of R.F. energy also involves the production of a substantial amount of heat which must be removed from the oscillation element to prevent it from becoming too hot. The above-mentioned arrangement has the major disadvantage that the thermal insulator inhibits the loss of heat from the oscillation element; very little heat can be produced in the oscillation element without its temperature rising considerably above the temperature at which the temperature sensing element is set to operate, thereby degrading performance, particularly the operating lifetime of the oscillation element. Moreover, if material of good thermal conductivity were to be used instead of the thermal insulator, a large amount of power would be required to maintain the heat-sink at the desired temperature when the ambient temperature was low. It may also be noted that simple ON-OFF control of a heating current of fixed magnitude is not well suited to accurate maintenance of a preset temperature in conditions where the ambient temperature may vary over a wide range.

European Patent Application No. 81400037.8, which has been published on 26/8/81 as EPO 034 510 A1 and which falls under Article 54(3) EPC, discloses a pulsed solid state system having solid state elements, specifically IMPATT diodes, responsive to drive pulses for generating RF signal pulses, wherein the solid state elements are preheated by a preheat pulse applied for a limited part of the drive pulse interpulse period, immediately before each drive pulse, so as to reduce "chirp" (variation in the RF frequency during the RF signal pulse). The current level and/or the duration of the preheat pulses may be controlled in accordance with the ambient temperatures. The Application also discloses that one can preheat such a diode by applying continuously up to about one-third of the normal pulse "on" current during the RF "off" period, that is, between drive current pulses. However, one of the disadvantages of this is that although coherent RF output is not present during application of the preheat current, RF noise will be generated, thus tending to jam the sensitive receivers needed to work with presently achievable solid state transmitters.

It is an object of the invention to provide an improved R.F. oscillator in which variations of the oscillating frequency with ambient temperature are reduced.

According to the invention, an R.F. oscillator arrangement as set forth in the opening paragraph is characterised in that the arrrangement comprises means for passing a heating current less than the critical current through the diode and controlling means for varying in operation of the arrangement, the heating of the diode by said heating current so as to reduce variations of said frequency with ambient temperature.

The present invention is based on the recognition of the fact that since a pulsed TRAPATT oscillator has a substantial critical current, a smaller current can be applied to the diode during the intervals between the pulses to heat the diode without generating any substantial microwave energy. This heating current (which may also be applied during the pulses) can be controlled to make the oscillation frequency substantially independent of ambient temperature by making the diode temperature substantially independent of ambient temperature.

Preferably, the controlling means comprises means for varying the magnitude of the heating current. In that case, the heating current may, in operation of the arrangement, be passed through the diode for substantially the whole of the interval between successive said pulses of direct current.

Suitably, the diode is mounted on a heat-sink which in operation is substantially at ambient temperature and wherein the controlling means comprises means for measuring the temperature of the heat-sink.

As an alternative, the controlling means may comprise means for measuring said frequency.

An embodiment of the invention will now be described by way of example with reference to the diagrammatic drawings in which:

Figure 1 is a graph of bias current against time;

Figure 2 illustrates variations of bias currents and frequency against temperature, and

Figure 3 illustrates an oscillator arrangement.

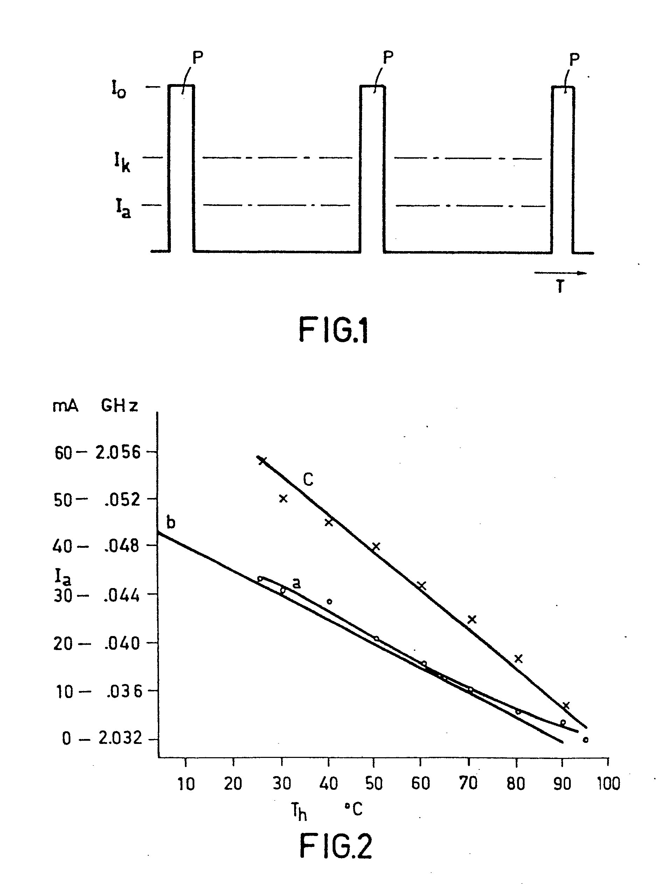

Referring to Figure 1 this illustrates the usual bias pulses P which are applied to a pulse TRAPATT oscillator: the amplitude of the pulses depends on the diode area and may be some 4—5 amps. Let the current $I_k$ represent the critical current below which TRAPATT oscillations do not take place and let $I_a$ represent a bias current which is less than the critical current $I_k$.

The invention utilises the thermal resistance which inevitably exists between the diode and its surroundings (particularly because the active region of the diode is generally very small), in that the thermal resistance enables a small heating power to maintain a substantial difference in temperature between the diode and its surroundings when the ambient temperature is below its maximum, but does not require any additional thermal resistance, which would undesirably restrict the dissipation of heat generated as a consequence of the production of R.F. energy during the pulses.

Consider a TRAPATT diode chip that is mounted on a heat sink and that is being operated at constant mean R.F. power (for example, so as to obtain optimum efficiency).

The temperature $T_c$ of the diode chip is given, approximately by the expression

$$T_c = T_h + [R_\theta . V_b . I_a] + [R_\theta . V_o . I_o . \delta . (1-\eta)] \quad (i)$$

where

$T_h$ is the temperature of the heat-sink,
$R_\theta$ is the thermal resistance from the diode chip to the heat-sink,
$V_b$ is the diode reverse breakdown voltage,
$I_a$ is a bias current below critical bias $I_k$
$V_o$ is the diode mean voltage during oscillation pulses,

$I_o$ is the diode mean current during oscillation pulses,

$\delta$ is the duty cycle, and

$\eta$ is the efficiency of the diode, expressed as a fraction.

We shall assume that the thermal resistance between the heat-sink and the surroundings is relatively small, so that the heat-sink is substantially at ambient temperature.

We shall take, for an S-band diode which is to operate with $T_h$ in the range $-40°C$ to $+90°C$, the following approximate figures:—

$R_\theta$ 20°C/Watt
$V_b$ 100 Volts
$V_o$ 70 Volts
$I_o$ 4 Amps
$\delta$ 0.1%
$\eta$ 1/3

To find the lowest operable temperature of the diode, let $I_a$ be zero for $T_h=90°C$. Then

$$T_c=90+[20.70.4.10^{-3}.(2/3)]=90+4$$
$$\text{approximately.}$$

We can now determine the value of $I_a$ needed to maintain the chip temperature constant, by the expression

$$T_c=94°C=T_h+(R_\theta.V_b.I_a)+4$$
and
$$I_a=(90-T_h)/R_\theta.V_b)$$

$$=(90-T_h)/2000 \qquad (ii)$$

This expression yields current $I_a$ of 35 mA for $T_h=20°C$ and 65 mA for $T_h=-40°C$: such currents are well below that necessary to initiate oscillations in the TRAPATT mode and if $I_a$ is plotted against $T_h$ the resultant graph is a straight line of negative slope.

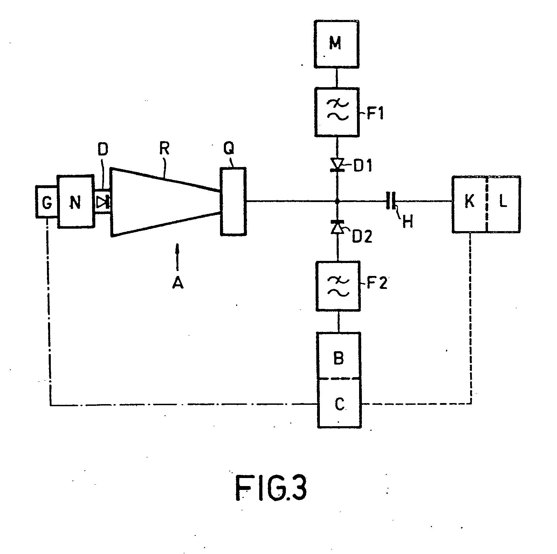

Figure 3 illustrates an arrangement comprising a TRAPATT oscillator A controlled through the usual low-pass filter F1 and a diode D1 from a modulator M which produces d.c. pulses P as illustrated in Figure 1. The oscillator A comprises an encapsulated TRAPATT diode D (with polarity as shown) mounted on a heat-sink N and feeding a tapered delay line R at the other end of which is a reflective step transition Q. In addition, a bias source B applies a continuous direct current $I_a$ less than the critical current for oscillation through a low-pass filter F2 and a diode D2 to the oscillator A, the source B comprising control means C for controlling the magnitude of the current $I_a$. Frequency-measuring means K are coupled to the oscillator A via a capacitor H (to provide isolation from the direct currents) and in this case include a load L to absorb the R.F. power from the oscillator. The temperature of the heat-sink of the oscillator is measured by a temperature-responsive device G.

Using a particular diode with a junction area of $4.10^{-4}$ cm$^2$ and with other parameters yielding equation (ii) above, measurements were made of the magnitudes of current $I_a$ necessary to maintain a constant frequency of 2.0333 GHz at various heat-sink temperatures $T_h$. Figures obtained are shown at Table 1 and are illustrated at $a$ in the graph of Figure 2, while the straight line $b$ in this graph is that representing expression (ii) above (both using the left-hand vertical scale).

Measurements were also made to show the frequency variations, with $T_h$, in the absence of heating current $I_a$ and these results are shown in Table 2 and drawn at $c$ in Figure 3 (right-hand vertical scale).

In one embodiment of the invention, the control means C are coupled to the temperature-responsive device G as indicated by the chain-dotted link in Figure 3 so that the heating current $I_a$ is controlled to keep the temperature of the diode D substantially constant. In an alternative embodiment, the control means C are coupled to the frequency-measuring means K as indicated by the dashed link in Figure 3 so that the heating current $I_a$ is controlled to keep the oscillation frequency substantially constant.

The superiority of an oscillator arrangement embodying the present invention over the arrangement described in the above-mentioned Japanese patent application is particularly marked for operation at high R.F. power levels and high ambient temperatures. Consider, for example, a TRAPATT diode with the following operating parameters:

$R_\theta$ 7°C/Watt
$\delta$ 2%
$\eta$ 1/3.

If such a diode is operated to produce a peak R.F. power (i.e. the R.F. power during the pulses) of 250 Watts, the mean R.F. power is 5 Watts and the rate of production of heat due to the conversion of d.c. to R.F. is 10 Watts. Hence the temperature of the diode is approximately 70°C above that of the heat-sink. If the diode is (as before) to operate over a range of ambient temperatures the upper limit of which is 90°C (for which the heating current $I_a$ is made zero), the temperature of the diode is approximately 160°C. Now the maximum temperature at which it can be operated if its operating life is not to be drastically shortened is not more than about 200°C. If thermal insulation between the heat-sink and the surroundings introduced an additional thermal resistance of only 7°C/Watt, an attempt to operate in these conditions would cause the diode temperature to exceed this maximum and hence would not be a practical possibility.

| TABLE 1 | | | TABLE 2 | |
|---|---|---|---|---|
| frequency=f=2.033 GHz | | | | |
| $T_h$(°C) | $I_a$(mA) | | $T_h$(°C) | f (GHz) |
| 95 | 0 | | 95 | 2.033 |
| 90 | 4 | | 90 | 2.035 |
| 80 | 6.9 | | 80 | 2.039 |
| 70 | 10.9 | | 70 | 2.042 |
| 60 | 16.1 | | 60 | 2.045 |
| 50 | 22 | | 50 | 2.048 |
| 40 | 28.4 | | 40 | 2.050 |
| 30 | 31.7 | | 30 | 2.052 |
| 26 | 33.6 | | 26 | 2.055 |

**Claims**

1. An R.F. oscillator arrangement comprising a TRAPATT diode operable to produce pulses of radio frequency energy when pulses of direct current greater than a critical current are applied to the diode, the radio frequency being dependent on the temperature of the diode, characterised in that the arrangement comprises means for passing a heating current less than the critical current through the diode and controlling means for varying, in operation of the arrangement, the heating of the diode by said heating current so as to reduce variations of said frequency with ambient temperature.

2. An oscillator arrangement as claimed in Claim 1 wherein the controlling means comprises means for varying the magnitude of the heating current.

3. An oscillator arrangement as claimed in Claim 2 wherein in operation of the arrangement the heating current is passed through the diode for substantially the whole of the interval between successive said pulses of direct current.

4. An oscillator arrangement as claimed in any of Claims 1 to 3 wherein the diode is mounted on a heat-sink which in operation is substantially at ambient temperature and wherein the controlling means comprises means for measuring the temperature of the heat-sink.

5. An oscillator arrangement as claimed in any of Claims 1 to 3 wherein the controlling means comprises means for measuring said frequency.

6. An oscillator arrangement as claimed in Claim 5 being a time-delay-triggered TRAPATT oscillator comprising a length of delay line connected across the diode and a trigger element in the form of a step transition from a high to a low impedance at the end of the delay line remote from the diode.

**Patentansprüche**

1. HF-Oszillatorschaltungsanordnung mit einer TRAPATT-Diode, die HF-Impulse erzeugt, wenn Gleichstromimpulse grösser als ein kritischer Strom der Diode zugeführt werden, wobei die Hochfrequenz abhängig ist von der Temperatur der Diode, dadurch gekennzeichnet, dass die Schaltungsanordnung Mittel enthält zum Hindurchlassen eines Heinzstromes kleiner als der kritische Strom durch die Diode und Regelmittel zum Variieren der Erwärmung der Diode durch den genannten Heizstrom im Betrieb der Schaltungsanordnung um Schwankungen der genannten Frequenz mit der Umgebungstemperatur zur verrigern.

2. Oszillatorschlatungsanordnung nach Anspruch 1, dadurch gekennzeichnet, dass die Regelmittel Mittel zum Variieren der Grösse des Heizstromes enthalten.

3. Oszillatorschaltungsanordnung nach Anspruch 2, dadurch gekennzeichnet, dass im Betrieb der Schaltungsanordnung der Heizstrom durch die Diode im wesentlichen während des ganzen Intervalls zwischen aufein-ander folgenden genannten Gleichstrom-impulsen hindurchgeführt wird.

4. Oszillatorschaltungsanordnung nach einem der Ansprüche 1 bis 3, dadurch gekennzeichnet, dass die Diode auf einem Wärmeableitblech angeordnet ist, das im Betrieb im wesentlichen die Umgebungstemperatur hat und dass die Regelmittel enthalten zum Messen der Temperatur des Wärmeableitbleches.

5. Oszillatorschaltungsanordnung nach einem der Ansprüche 1 bis 3, dadurch gekennzeichnet, dass die Regelmittel Mittel zum Messen der genannten Frequenz enthalten.

6. Oszillatorschaltungsanordnung nach Anspruch 5, dadurch gekennzeichnet, dass es sich um einen zeitverzögerungsgetriggerten TRAPATT-Oszillator handelt mit einer Verzögerungsleitung verbunden mit der Diode und mit einem Triggerelement im Form eines Stufen-überganges von einer hohen zu einer niedrigen Impedanz am von der Diode abgewandten Ende der Verzögerungsleitung.

**Revendications**

1. Oscillateur hyperfréquence comportant une diode TRAPATT pouvant être amenée à produire des impulsions d'énergie hyperfréquence lorsque des impulsions de courant continu supérieur à un courant critique sont appliquées à cette diode, la fréquence considérée étant fonction de la température de la diode, caractérisé en ce que l'oscillateur comporte des moyens pour faire passer dans la diode un courant de chauffe dont l'intensité est inférieure à celle du courant critique, ainsi que des moyens de commande pour faire varier au cours du fonctionnement de l'oscillateur le chauffe de la diode par ledit courant de chauffe pour réduire de la sorte les variations de ladite fréquence dues au changement de la température ambiante.

2. Oscillateur selon la revendication 1, caractérisé en ce que les moyens de commande comportent des moyens pour faire varier l'intensité du courant de chauffe.

3. Oscillateur selon la revendication 2, caractérisé en ce que, lors du fonctionnement de l'oscillateur, le courant de chauffe passe par la diode durant pratiquement l'intervalle complet entre lesdites impulsions de courant continu.

4. Oscillateur selon l'une quelconque des revendications 1 à3, caractérisé en ce que la diode est montée sur un élément d'evacuation de chaleur qui lors due fonctionnement, est pratiquement à la température ambiante, alors que les moyens de commande comportent des moyens pour mesurer la température de l'élément d'évacuation de chaleur.

5. Oscillateur selon l'une quelconque des revendications 1 à 3, caractérisé en ce que les moyens de commande comportent des moyens pour mesurer ladite fréquence.

6. Oscillateur selon la revendication 5, caractérisé en ce qu'il consiste en un oscillateur TRAPATT à déclenchement retardé comportant une longueur de ligne de retardement branchée entre la diode et un élément de transition d'une valeur d'impédance élevée à une valeur d'impédance faible placé de côté de la ligne de retardement situé à l'opposé de la diode.

FIG.1

FIG.2

1

FIG.3